# EUROPEAN PATENT APPLICATION

(11) **EP 1 995 774 A2**
(43) Date of publication of application: **26.11.2008**
(21) Application number: 08156822.2
(22) Date of filing: 23.05.2008
(51) Int. Cl.: H01L 23/373

(54) **Semiconductor device**

(30) Priority: 25.05.2007 JP 2007139028
(71) Applicant: KABUSHIKI KAISHA TOYOTA JIDOSHOKKI, Kariya-shi, Aichi 448-8671 (JP); SHOWA DENKO KABUSHIKI KAISHA, Tokyo 105-8518 (JP)
(72) Inventor: Nishi, Shinsuke, Kariya-shi Tochigi 448-8671 (JP); Watanabe, Shintaro, Kariya-shi Aichi 448-8671 (JP); Mori, Shogo, Kariya-shi Aichi 448-8671 (JP); Nakagawa, Shintaro, Oyama-shi Tochigi 323-8678 (JP); Suzuyama, Takeshi, Oyama-shi Tochigi 323-8678 (JP); Ichiyanagi, Shigeharu, Oyama-shi Tochigi 323-8678 (JP)
(74) Representative: TBK-Patent

(57) **Abstract**

A semiconductor device is disclosed that includes a ceramic substrate having first and second surfaces, a semiconductor element, a radiator, and an interposed portion located between the second surface and the radiator. The interposed portion has coupling regions that couple the second surface to the radiator, and non-coupling regions that do not couple the second surface to the radiator. Each non-coupling region is formed as an elongated groove. In the group of the non-coupling regions, the width of the outermost non-coupling region in the interposed portion is greater than the width of the innermost non-coupling region in the interposed portion. Regarding an adjacent pair of the non-coupling regions in the width direction, the width of the outer non-coupling region is greater than or equal to the width of the inner non-coupling region.

## Description

### BACKGROUND OF THE INVENTION

The present invention relates to a semiconductor device including a ceramic substrate that has a first surface, to which a semiconductor element is coupled, and a second surface, to which a radiator is coupled.

Conventionally, modularized semiconductor devices are known. In such a semiconductor device, metal layers are respectively provided on both of the front and back sides of a ceramic substrate, which is, for example, made of aluminum nitride. A semiconductor element is coupled (joined) to the front side metal layer, and a heat sink (radiator) is coupled (joined) to the back side metal layer. The heat sink radiates heat generated by the semiconductor element. Semiconductor devices are required to maintain heat radiating performance of the heat sink for an extended period of time. However, depending on the use conditions, cracks may occur at junction portions between the ceramic substrate and the back side metal layer due to thermal stress generated by the difference in coefficient of linear expansion between the metal layer and the heat sink. Further, when expanding, the cracks may cause peeling, which degrades the heat radiating performance.

To overcome such a drawback, Japanese Laid-Open Patent Publication No. 1-106451 discloses a technique shown below. As shown in Figs. 8A and 8B, an insulating plate 90 for semiconductor element disclosed in the publication has a front side, on which an semiconductor element 91 is mounted, and a back side, which forms a metallized surface 92. A heat sink 96 is joined to the metallized surface 92. The metallized surface 92 has a first metallized portion 92a located directly below a section on which the semiconductor element 91 is mounted, and second metalized portions 92b, which are located about the first metallized portion 92a, and separated from the first metallized portion 92a by slit portions 93. The first metallized portion 92a and the heat sink 96 are joined to each other by a first junction portion 95a, whish is formed of solder. The second metallized portions 92b and the heat sink 96 are joined to each other by second junction portions 95b, whish are formed of solder.

In the case where the insulating plate 90 of the above publication is used, even if cracks occur at four corners and edges of the insulating plate 90, the slit portions 93 prevent the cracks from reaching the first junction portion 95a from the second junction portions 95b. Also, since the first junction portion 95a and the second junction portions 95b are separated by the slit portions 93, the size of the first junction portion 95a is small. Thus, the thermal stress (thermal strain) acting on the first junction portion 95a, which joins the heat sink 96 and the insulating plate 90 to each other, is minimized. This suppresses the occurrence of cracks.

Heat generated by the semiconductor element 91 is sequentially conducted to the first and second junction portions 95a, 95b from the insulating plate 90, to which the semiconductor element 91 is joined, and then radiated through the heat sink 96. Thus, to improve the heat radiating performance, the joining area of the insulating plate 90 and the heat sink 96 with the first and second junction portions 95a, 95b in between is preferably as large as possible.

However, since thermal stress acts between the insulating plate 90 and the heat sink 96 as described above, the slit portions 93 are preferably large and the area of the first junction portion 95a is preferably small in order to reduce such thermal stress. That is, in the semiconductor device, the joining area of the insulating plate 90 and the heat sink 96 with the first junction portion 95a in between is preferably small to reduce the thermal stress. In contrast, however, too small a joining area reduces sections through which heat is conducted, and lowers the heat radiating performance. Thus, the balance between measures against thermal stress and heat radiating performance needs to be considered.

### SUMMARY OF THE INVENTION

Accordingly, it is an objective of the present invention to provide a semiconductor device that achieves a superior heat radiating performance, while preventing cracks and peeling due to thermal stress.

To achieve the foregoing objective and in accordance with one aspect of the present invention, a semiconductor device including a ceramic substrate, a semiconductor element, a radiator, and an interposed portion is provided. The ceramic substrate has a first surface and a second surface that is opposite to the first surface. The semiconductor element is coupled to the first surface. The radiator coupled to the second surface. The interposed portion is provided between the second surface and the radiator. The interposed portion has a plurality of coupling regions that couple the second surface to the radiator, and a plurality of non-coupling regions that do not couple the second surface to the radiator. Each non-coupling region is formed as an elongated groove. The non-coupling regions include at least one group of parallel non-coupling regions arranged in a width direction, which is perpendicular to the extending direction of the non-coupling region. In the group of the non-coupling regions, the width of the outermost non-coupling region in the interposed portion is greater than the width of the innermost non-coupling region in the interposed portion. Regarding an adjacent pair of the non-coupling regions in the width direction, the width of the outer non-coupling region is greater than or equal to the width of the inner non-coupling region.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a cross-sectional view illustrating a semiconductor device according to one embodiment of the present invention;
Figs. 2A to 2C are a plan view, a side view, and a front view showing the stress relaxation member shown in Fig. 1;
Fig. 3 is a perspective view illustrating the stress relaxation member shown in Fig. 2A;
Fig. 4 is a side view showing transverse grooves in a stress relaxation member according to a modified embodiment;
Fig. 5 is a plan view showing non-coupling regions in a stress relaxation member according to a modified embodiment;
Fig. 6 is a plan view showing non-coupling regions in a stress relaxation member according to a modified embodiment;
Fig. 7 is a cross-sectional view illustrating a semiconductor device according to a modified embodiment;

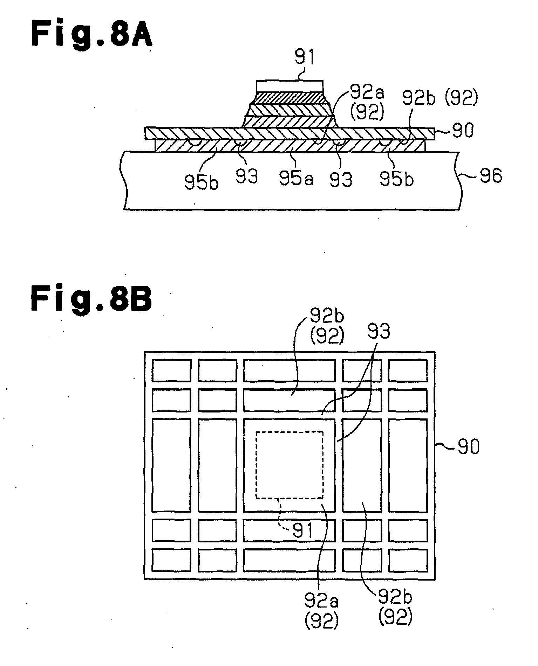

Fig. 8A is a cross-sectional view illustrating a prior art semiconductor device; and
Fig. 8B is a diagram showing an insulating plate for the semiconductor device shown in Fig. 8A.

### DETAILED DESCRIPTION OF THE PREFERRED EMBODIMENTS

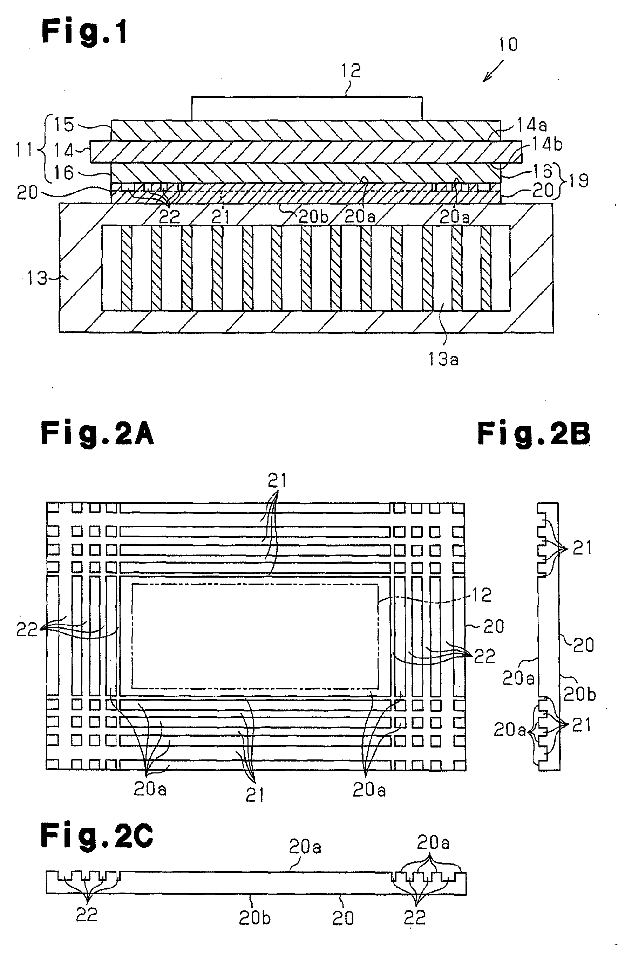

One embodiment of the present invention will now be described with reference to Figs. 1 to 3.

As shown in Fig. 1, a semiconductor device 10 includes a circuit board 11, a semiconductor element 12 joined to the circuit board 11, a heat sink 13 functioning as a radiator, and a stress relaxation member 20 located between the circuit board 11 and the heat sink 13. The circuit board 11 is provided with a ceramic substrate (insulated substrate) 14 that has a first surface 14a (front side) and a second surface 14b (back side), which is opposite to the first surface 14a. The circuit board 11 also includes a metal circuit 15, which is directly joined to the first surface 14a, and a metal plate 16, which is directly joined to the second surface 14b. The semiconductor element 12 is joined to the metal circuit 15, so that the semiconductor element 12 and the ceramic substrate 14 are coupled to each other by the metal circuit 15.

The semiconductor element 12 may be, for example, an IGBT (Insulated Gate Bipolar Transistor), a MOSFET, or a diode. One semiconductor element 12 is joined to the circuit board 11 (metal circuit 15). The metal plate 16 joined to the second surface 14b functions as a metal layer joining the ceramic substrate 14 and the stress relaxation member 20 to each other. The stress relaxation member 20 is directly brazed to the metal plate 16 and the heat sink 13. The semiconductor element 12 and the heat sink 13 are coupled to each other with the circuit board 11 and the stress relaxation member 20 in between. The metal plate 16 and the stress relaxation member 20 form an interposed portion 19 between the second surface 14b of the ceramic substrate 14 and the heat sink 13.

The ceramic substrate 14 is formed of, for example, aluminum nitride, alumina, or silicon nitride. The metal circuit 15 and the metal plate 16 are formed of aluminum. The heat sink 13 is formed of aluminum. The aluminum refers to aluminum and aluminum alloy. The metal circuit 15, the metal plate 16, and the heat sink 13 may be formed of a material having a high thermal conductivity (for example, copper and copper alloys), other than aluminum. Cooling medium passages 13a, through which cooling medium (for example, cooling water) flows, are formed in the heat sink 13.

The stress relaxation member 20 will now be described in detail.

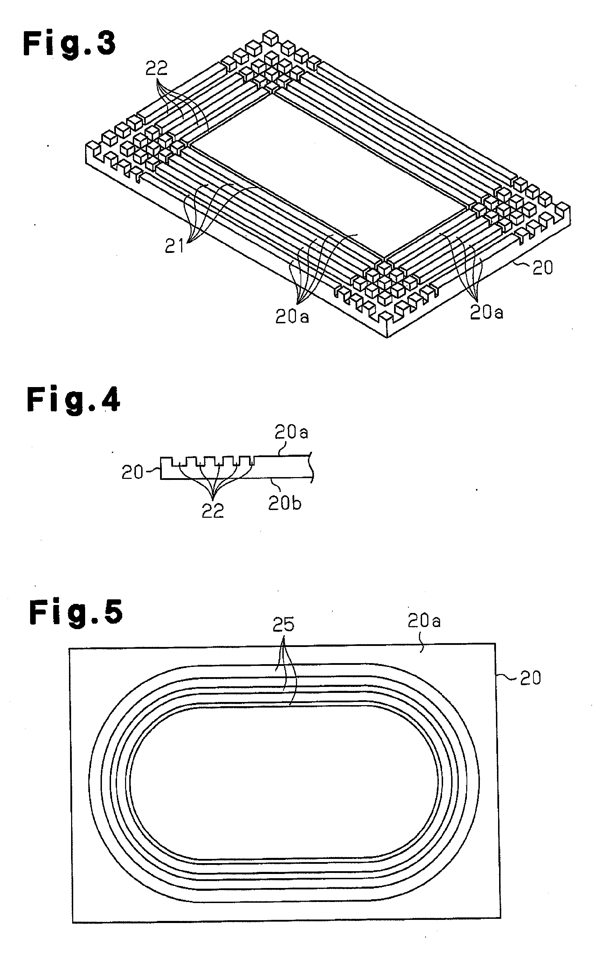

As shown in Figs. 2A to 2C, and 3, the stress relaxation member 20 is formed of a material having a high thermal conductivity such as aluminum, and is shaped like a rectangular flat plate when viewed from above. In the stress relaxation member 20, longitudinal grooves 21 and transverse grooves 22 are formed on a first surface (front side), which is an upper side as viewed in Fig. 1. The longitudinal grooves 21 and the transverse grooves 22 each have an elongated shape. In the present embodiment, the longitudinal grooves 21 and the transverse grooves 22 form stress relaxing spaces in the stress relaxation member 20. In the stress relaxation member 20, longitudinal grooves 21 and transverse grooves 22 are not formed on a second surface (back side), which is a bottom side as viewed in Fig. 1. The second surface is thus a smooth surface. On the first surface of the stress relaxation member 20, sections other than the longitudinal grooves 21 and the transverse grooves 22 form junction sections 20a, which are joined to the metal plate 16. On the other hand, the entire second surface of the stress relaxation member 20 forms a junction section 20b joined to the heat sink 13.

The longitudinal grooves 21 and the transverse grooves 22 will now be described in detail.

The longitudinal grooves 21 extend along a pair of first sides (long sides) located at opposite positions in the stress relaxation member 20. Sides of the stress relaxation member 20 that are perpendicular to the first sides (long sides) are referred to as second sides (short sides). Both ends of each longitudinal groove 21 in the extending direction are open to the outside at edges extending along the second sides of the stress relaxation member 20. That is, the longitudinal grooves 21 are through grooves that extend along the entire stress relaxation member 20 in a direction along the first sides. On the other hand, the transverse grooves 22 extend along a pair of second sides (short sides) located at opposite positions in the stress relaxation member 20. Both ends of each transverse groove 22 in the extending direction are open to the outside at edges extending along the first sides of the stress relaxation member 20. That is, the transverse grooves 22 are through grooves that extend along the entire stress relaxation member 20 in a direction along the second sides.

The longitudinal grooves 21 and the transverse grooves 22 are formed by cutting the first surface of the stress relaxation member 20 with a cutting tool. The longitudinal grooves 21 and the transverse grooves 22 are formed to be recessed from the first surface of the stress relaxation member 20, but do not extend through the thickness of the stress relaxation member 20. The longitudinal grooves 21 and the transverse grooves 22 are formed on the first surface of the stress relaxation member 20 to be perpendicular to each other, and the longitudinal grooves 21 and the transverse grooves 22 make the grid-like first surface of the stress relaxation member 20. Sections each of which surrounded by longitudinal grooves 21 and transverse grooves 22 in the first surface form rectangular junction sections 20a as viewed from above.

In a region closer to each first side (long side), a number of the longitudinal grooves 21, which form one group are formed. In a region closer to each second side (short side), a number of the transverse grooves 22, which form one group are formed. In each of the longitudinal grooves 21 and the transverse grooves 22, a direction perpendicular to the direction in which the groove extends is defined as a width direction. The dimension of each of the grooves 21, 22 along the width direction is defined as the width.

Among the longitudinal grooves 21 close to each first side of the stress relaxation member 20, the width of the innermost longitudinal groove 21, that is, the width of the longitudinal groove 21 that is farthest from the edge of the interposed portion 19 in the width direction of the longitudinal grooves 21, is the smallest. Further, among the longitudinal grooves 21 close to each first side of the stress relaxation member 20, the width of the outermost longitudinal groove 21, that is, the width of the longitudinal groove 21 that is closest to the edge of the interposed portion 19 in the width direction of the longitudinal grooves 21, is the greatest. The closer to the outer edge of the stress relaxation member 20 in the width direction of the longitudinal grooves 21, the greater the width of the longitudinal grooves 21 becomes. Therefore, in each adjacent pair of the longitudinal grooves 21 in the width direction, the outside longitudinal groove 21 is wider than the inside longitudinal groove 21. Regarding the junction sections 20a formed between adjacent pairs of the longitudinal grooves 21 in the width direction, each adjacent pair of the junction sections 20a have the same area.

As in the case of the longitudinal grooves 21, among the transverse grooves 22 close to each second side of the stress relaxation member 20, the width of the innermost transverse groove 22, that is, the width of the transverse groove 22 that is farthest from the edge of the interposed portion 19 in the width direction of the longitudinal grooves 22, is the smallest. Further, among the transverse grooves 22 close to each second side of the stress relaxation member 20, the width of the outermost transverse groove 22, that is, the width of the transverse groove 22 that is closest to the edge of the interposed portion 19 in the width direction of the transverse grooves 22, is the greatest. The closer to the outer edge of the stress relaxation member 20 in the width direction of the transverse grooves 22, the greater the width of the transverse grooves 22 becomes. Therefore, in each adjacent pair of the transverse grooves 22 in the width direction, the outside transverse groove 22 is wider than the inside transverse groove 22. Regarding the junction sections 20a formed between adjacent pairs of the transverse grooves 22 in the width direction, each adjacent pair of the junction sections 20a have the same area.

As shown in Fig. 1, spaces are formed in the semiconductor device 10 between the second surface 14b of the ceramic substrate 14 and the heat sink 13 by the longitudinal grooves 21 and the transverse grooves 22. Therefore, at positions where the longitudinal grooves 21 and the transverse grooves 22 are formed, the second surface 14b of the ceramic substrate 14 and the heat sink 13 are in a non-coupling state. Thus, the longitudinal grooves 21 and the transverse grooves 22 form non-coupling regions, in which the second surface 14b and the heat sink 13 are not coupled to each other, between the second surface 14b of the ceramic substrate 14 and the heat sink 13.

On the other hand, the stress relaxation member 20 is located between the second surface 14b of the ceramic substrate 14 and the heat sink 13 such that the stress relaxation member 20 is joined to the metal plate 16 in the junction sections 20a, which are sections of the first surface except for the longitudinal grooves 21 and the transverse grooves 22, and that the stress relaxation member 20 is joined to the heat sink 13 at the junction section 20b. Therefore, the second surface 14b of the ceramic substrate 14 and the heat sink 13 are coupled to each other with the metal plate 16 and the stress relaxation member 20 in between. Thus, the metal plate 16 and sections in the stress relaxation member 20 except for the longitudinal grooves 21 and the transverse grooves 22 form coupling regions that couple the second surface 14b of the ceramic substrate 14 and the heat sink 13 to each other between the second surface 14b and the heat sink 13.

Also, in the semiconductor device 10, a coupling region of the stress relaxation member 20 is located at a position that corresponds to a surface of the semiconductor element 12 that is coupled to the ceramic substrate 14 (mounting surface). That is, the longitudinal grooves 21 and the transverse grooves 22 are not located in a position directly below the coupling surface of the semiconductor element 12 to the ceramic substrate 14. The junction section 20a that is surrounded by the longitudinal grooves 21 and the transverse grooves 22 is located at this position. The longitudinal grooves 21 and the transverse grooves 22 closest to the junction section 20a that is directly below the semiconductor element 12 are the innermost ones among the longitudinal grooves 21 and the transverse grooves 22. The widths of the innermost longitudinal and transverse grooves 21, 22 are smaller than those of the other the longitudinal grooves 21 and the transverse grooves 22. The junction sections 20a adjacent to the junction section 20a directly below the coupling surface of the semiconductor element 12 are arranged to be closest possible to the junction section 20a directly below the coupling surface of the semiconductor element 12, in spite of the existence of the longitudinal grooves 21 and the transverse grooves 22. In the interposed portion 19 between the second surface 14b of the ceramic substrate 14 and the heat sink 13, ends of the longitudinal grooves 21 and the transverse grooves 22 along the extending directions are open to the outside at the edges of the interposed portion 19.

The semiconductor device 10 configured as described above is applied, for example, to a driving device of a vehicle electric motor, and controls electricity supplied to the vehicle electric motor in accordance with the driving conditions of the vehicle. Heat generated by the semiconductor element 12 is conducted to the heat sink 13 through the circuit board 11 and the stress relaxation member 20. When the heat generated by the semiconductor element 12 is conducted to the heat sink 13, the circuit board 11 and the heat sink 13 are heated and thermally expanded. When the semiconductor element 12 stops generating heat, the temperature of the circuit board 11 and the heat sink 13 is lowered, and the circuit board 11 and the heat sink 13 are thermally shrunk. At thermal expansion and thermal shrinkage, thermal stress is generated in the semiconductor device 10 due to the difference in coefficient of linear expansion among the members (the heat sink 13, the ceramic substrate 14, the metal circuit 15, and the metal plate 16).

However, since the semiconductor device 10 of the present embodiment has stress relaxing spaces (non-coupling regions) formed by the longitudinal grooves 21 and the transverse grooves 22 in the stress relaxation member 20, the stress relaxing spaces allow deformation of the stress relaxation member 20, and the thermal stress is relaxed accordingly. As a result, cracks and peeling are prevented from occurring in the junction portions between the ceramic substrate 14 and the metal plate 16.

The thermal stress acting on the semiconductor device 10 increases toward the outer edges. The widths of the longitudinal grooves 21 and the transverse grooves 22 increase toward the outer edges of the stress relaxation member 20. Thus, the widest longitudinal and transverse grooves 21, 22 are arranged at regions to which the largest thermal stress is applied. This allows the stress relaxation member 20 to be greatly deformed, and the thermal stress is reliably relaxed.

Also, heat generated by the semiconductor element 12 is conducted to the heat sink 13 through the ceramic substrate 14, the metal plate 16, and the stress relaxation member 20 (coupling region). The heat conducted to the heat sink 13 is then conducted to the cooling medium flowing through the cooling medium passages 13a in the heat sink 13, and removed. That is, since the heat sink 13 is forcibly cooled by the cooling medium flowing through the cooling medium passages 13a, the heat generated by the semiconductor element 12 is efficiently removed. As a result, the semiconductor element 12 is cooled from the side closer to the circuit board 11.

In the semiconductor device 10, one of the junction sections 20a (coupling regions) of the stress relaxation member 20 is located directly below the coupling surface of the semiconductor element 12 to the ceramic substrate 14, with the circuit board 11 in between. Thus, heat that is conducted directly downward from the semiconductor element 12 is conducted to the heat sink 13 through the coupling region of the stress relaxation member 20. Further, the heat generated by the semiconductor element 12 is conducted to the circuit board 11 and the stress relaxation member 20 in a spreading manner.

The stress relaxation member 20 has the longitudinal grooves 21 and the transverse grooves 22, which relax thermal stress. The longitudinal grooves 21 and the transverse grooves 22 that are closest to the junction section 20a (coupling region) directly below the semiconductor element 12 have the smallest widths. The widths of the grooves 21, 22 increases toward the outside of the stress relaxation member 20. Therefore, even with the longitudinal grooves 21 and the transverse grooves 22 formed on the stress relaxation member 20, the closer to the semiconductor element 12, the larger the joining area (coupling region) of the stress relaxation member 20 to the metal plate 16. This increases the heat radiating performance. Thus, heat generated by the semiconductor element 12 is efficiently conducted to the heat sink 13 through the coupling regions.

Although the stress relaxation member 20 is held between the metal plate 16 and the heat sink 13, both ends of each of the longitudinal grooves 21 and the transverse grooves 22 are open to the outside at edges of the stress relaxation member 20. Therefore, heat conducted to the stress relaxation member 20 does not stay in the stress relaxation member 20, but is released to the outside of the stress relaxation member 20 (the interposed portion 19) from the longitudinal grooves 21 and the transverse grooves 22.

The embodiment has the following advantages.
(1) The interposed portion 19 formed by the metal plate 16 and the stress relaxation member 20 is provided between the second surface 14b of the ceramic substrate 14 and the heat sink 13, and the elongated longitudinal and transverse grooves 21, 22 are formed in the first surface of the stress relaxation member 20. The longitudinal grooves 21 and the transverse grooves 22 form the non-coupling regions, in which the second surface 14b of the ceramic substrate 14 and the heat sink 13 are not coupled to each other. The outermost longitudinal and transverse grooves 21 and 22 have the greatest widths. Therefore, thermal stress, which concentrates in outer sections, is reliably relaxed. This prevents cracks and peeling from occurring in the junction portions between the ceramic substrate 14 and the metal plate 16. The longitudinal and transverse grooves 21, 22 that are located closest to the junction section 20a directly below the coupling surface of the semiconductor element 12 to the ceramic substrate 14 have the smallest widths. Thus, even with the longitudinal grooves 21 and the transverse grooves 22 for relaxing thermal stress, the other junction sections 20a can be arranged as close as possible to the junction section 20a directly below the semiconductor element 12. This secures a large joining area of the stress relaxation member 20 (the junction sections 20a) to the metal plate 16, thereby improving the heat radiating performance. Thus, in the semiconductor device 10 having the stress relaxation member 20, cracks and peeling due to thermal stress are prevented from occurring in the junction portions with the ceramic substrate 14, while an improved heat radiating performance is ensured.
(2) The stress relaxation member 20 is provided between the second surface 14b of the ceramic substrate 14 and the heat sink 13, and the longitudinal grooves 21 and the transverse grooves 22 are formed in the stress relaxation member 20. By relaxing thermal stress with the stress relaxation member 20 and adjusting the widths of the longitudinal grooves 21 and the transverse grooves 22, cracks and peeling are prevented from occurring at the junction portions between the ceramic substrate 14 and the metal plate 16, while ensuring a superior heat radiating performance. Therefore, compared to a semiconductor device having no stress relaxation member 20 between the second surface 14b of the ceramic substrate 14 and the heat sink 13, the semiconductor device 10 effectively relaxes thermal stress, and reliably prevents the occurrence of cracks and peeling. Also, non-coupling regions (stress relaxing spaces) are formed in the stress relaxation member 20, which is separate from the second surface of the ceramic substrate 14 and the heat sink 13, so that the non-coupling regions can be machined separately from the ceramic substrate 14. This facilitates the forming of the non-coupling regions.
(3) The longitudinal grooves 21 and the transverse grooves 22 are formed by cutting the first surface of the stress relaxation member 20. Therefore, a structure for attaining a superior heat radiating performance is easily obtained while preventing the occurrence of cracks and peeling in the junction portions between the ceramic substrate 14 and the metal plate 16.
(4) The longitudinal grooves 21 extend along the entire length of the first sides (long sides) of the stress relaxation member 20, and both ends of each longitudinal groove 21 are open at the edges extending along the second sides (short sides) of the stress relaxation member 20 (the interposed portion 19). The transverse grooves 22 extend along the entire length of the second sides (short sides) of the stress relaxation member 20, and both ends of each transverse groove 22 are open at the edges extending along the first sides (long sides) of the stress relaxation member 20 (the interposed portion 19). Therefore, with the stress relaxation member 20 held between the second surface 14b of the ceramic substrate 14 and the heat sink 13, heat conducted to the stress relaxation member 20 (coupling regions) is readily released to the outside from the stress relaxation member 20 (the interposed portion 19) through the longitudinal grooves 21 and the transverse grooves 22. That is, heat is prevented from remaining in the longitudinal grooves 21 and the transverse grooves 22, and heat radiation from the stress relaxation member 20 is promoted. Thus, compared to, for example, a semiconductor device in which the longitudinal grooves 21 and the transverse grooves 22 are not open at the edges of the stress relaxation member 20, the semiconductor device 10 has a superior heat radiating performance of the semiconductor element 12.
(5) The widths of the longitudinal grooves 21 and the transverse grooves 22 increase toward the outer edges of the stress relaxation member 20. The magnitude of thermal stress acting on the semiconductor device 10 increases toward the edges of the semiconductor device 10, and decreases toward the center. The longitudinal grooves 21 and the transverse grooves 22 formed in the stress relaxation member 20 are configured in accordance with the magnitude of thermal stress. This allows thermal stress to be efficiently relaxed.
(6) The heat sink 13, the metal plate 16 of the circuit board 11, and the stress relaxation member 20 are formed of the same material. Therefore, compared to a semiconductor device having members made of different materials, the formation of joined interfaces, which hinders heat conduction, is suppressed in the semiconductor device 10. The degree of heat conduction from the circuit board 11 to the heat sink 13 is thus increased.

It should be apparent to those skilled in the art that the present invention may be embodied in many other specific forms without departing from the spirit or scope of the invention. Particularly, it should be understood that the invention may be embodied in the following forms.

At least in either of the longitudinal grooves 21 and the transverse grooves 22, the width of the outermost groove may be largest, the width of the innermost groove may be smallest, and the widths of at least one adjacent pair of the grooves between the outermost groove and the innermost groove may be the same. For example, as shown in Fig. 4, in the case where three transverse grooves 22 between the outermost transverse groove 22 and the innermost transverse groove 22 are referred to as first to third transverse grooves 22, the width of the first transverse groove 22, which is inside of and adjacent to the outermost transverse groove 22, and the width of the second transverse groove 22, which is inside of and adjacent to the first transverse groove 22, may be equal, and the width of the third transverse groove 22, which is inside of and adjacent to the second transverse groove 22, may be smaller.

As shown in Fig. 5, annularly extending grooves 25 may be formed in the first surface of the stress relaxation member 20, so that non-coupling regions are formed by the grooves 25. It is preferable that the closer to the outer edge of the stress relaxation member in the width direction of the grooves 25, the greater the width of the grooves 25 becomes.

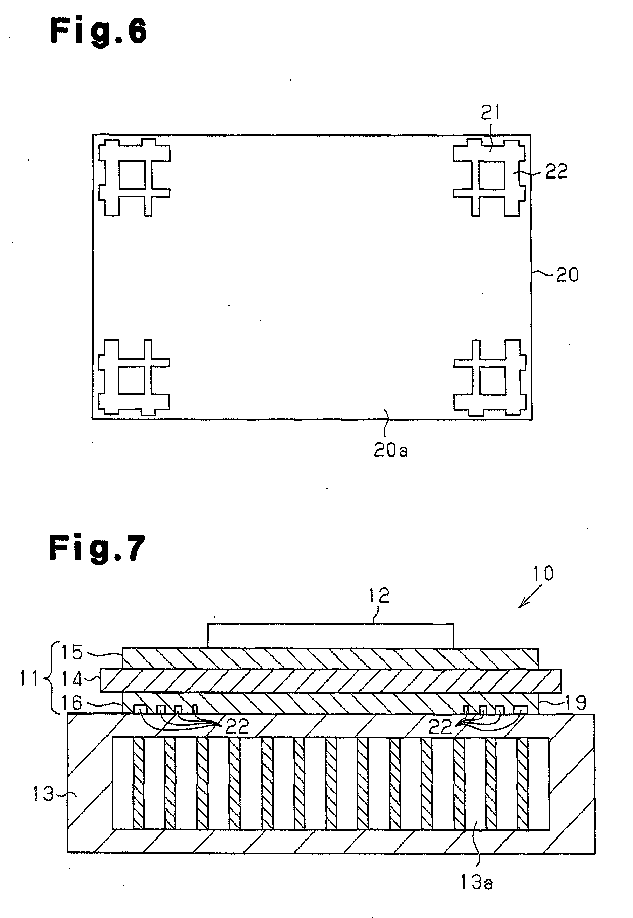

As shown in Fig. 6, longitudinal grooves 21 and transverse grooves 22 may be combined to form non-coupling regions at corners of the stress relaxation member 20.

As shown in Fig. 7, the stress relaxation member 20 may be omitted so that the metal plate 16 of the circuit board 11 is directly joined to the heat sink 13. In this semiconductor device 10, the interposed portion 19 is formed by only the metal plate 16. The longitudinal grooves 21 and the transverse grooves 22 (only the transverse grooves 22 are shown in Fig. 7) are formed in the metal plate 16, so that non-coupling regions are formed. The grooves are formed in the metal plate 16 by etching.

The stress relaxation member 20 may be formed by a plurality of separate segments. The segments are joined (brazed) to the heat sink 13 such that a gap exists between each adjacent pair of the segments. Coupling regions are formed by the segments, and non-contacting regions are formed by the gaps extending like elongated grooves between the segments. In this case, the gaps serving as non-coupling regions extend through the thickness of the stress relaxation member 20.

The longitudinal grooves 21 and the transverse grooves 22 do not need to be open to the outside at the edges of the stress relaxation member 20.

The non-coupling regions may extend to form a triangular shape, a star shape, or an elliptic shape.

The heat sink 13, the metal plate 16, and the stress relaxation member 20 may be made of metal materials of the same type. "Metal materials of the same type" refers to materials having the same basic component, and if one of the materials is melted and joined to another material, no interface is formed therebetween.

The present examples and embodiments are to be considered as illustrative and not restrictive and the invention is not to be limited to the details given herein, but may be modified within the scope and equivalence of the appended claims.

A semiconductor device is disclosed that includes a ceramic substrate having first and second surfaces, a semiconductor element, a radiator, and an interposed portion located between the second surface and the radiator. The interposed portion has coupling regions that couple the second surface to the radiator, and non-coupling regions that do not couple the second surface to the radiator. Each non-coupling region is formed as an elongated groove. In the group of the non-coupling regions, the width of the outermost non-coupling region in the interposed portion is greater than the width of the innermost non-coupling region in the interposed portion. Regarding an adjacent pair of the non-coupling regions in the width direction, the width of the outer non-coupling region is greater than or equal to the width of the inner non-coupling region.

## Claims

1. A semiconductor device comprising:
a ceramic substrate (14) having a first surface (14a) and a second surface (14b) that is opposite to the first surface (14a);
a semiconductor element (12) coupled to the first surface (14a);
a radiator (13) coupled to the second surface (14b); and
an interposed portion (19) provided between the second surface (14b) and the radiator (13),
**characterized in that** the interposed portion (19) has a plurality of coupling regions (20a) that couple the second surface (14b) to the radiator (13), and a plurality of non-coupling regions (21, 22) that do not couple the second surface (14b) to the radiator (13), each non-coupling region (21, 22) being formed as an elongated groove, and wherein the non-coupling regions (21, 22) include at least one group of parallel non-coupling regions (21, 22) arranged in a width direction, which is perpendicular to the extending direction of the non-coupling region, and
wherein, in the group of the non-coupling regions (21, 22), the width of the outermost non-coupling region (21, 22) in the interposed portion (19) is greater than the width of the innermost non-coupling region (21, 22) in the interposed portion (19), and wherein, regarding an adjacent pair of the non-coupling regions (21, 22) in the width direction, the width of the outer non-coupling region (21, 22) is greater than or equal to the width of the inner non-coupling region (21, 22).

2. The semiconductor device according to claim 1, **characterized in that** the interposed portion (19) includes a metal layer (16) joined to the second surface (14b), and a stress relaxation member (20) located between the metal layer (16) and the radiator (13), the stress relaxation member (20) being made of a material having a high thermal conductivity,
wherein the metal layer (16) and the stress relaxation member (20) form the coupling regions (20a), and the stress relaxation member (20) defining stress relaxing spaces (21, 22) forms the non-coupling regions (21, 22).

3. The semiconductor device according to claim 2, **characterized in that** the non-coupling regions (21, 22) are formed by cutting the stress relaxation member (20).

4. The semiconductor device according to claim 2, **characterized in that** the radiator (13) is a heat sink, and wherein the metal layer (16), the heat sink (13), and the stress relaxation member (20) are made of metal materials of the same type.

5. The semiconductor device according to claim 1, **characterized in that** the interposed portion (19) includes a metal layer (16) that is joined to the second surface (14b) and to the radiator (13), and wherein the metal layer (16) forms the coupling regions (2.0a), and has grooves forming the non-coupling regions (21, 22).

6. The semiconductor device according to any one of claims 1 to 5, **characterized in that** ends of each non-coupling region (21, 22) in the extending direction are open to the outside at edges of the interposed portion (19).

7. The semiconductor device according to any one of claims 1 to 6, **characterized in that**, in the group of non-coupling regions (21, 22), the closer to the outside of the interposed portion (19) in the width direction, the greater the width of the non-coupling regions (21, 22) becomes.

8. The semiconductor device according to any one of claims 1 to 7, **characterized in that** the width of the coupling region (20a) between each adjacent pair of the non-coupling regions (21, 22) is equal to the width of the coupling region (20a) between any other adjacent pair of the non-coupling regions (21, 22).
